# EUROPÄISCHE PATENTANMELDUNG

(11) **EP 3 089 185 A1**
(43) Veröffentlichungstag der Anmeldung: **02.11.2016**
(21) Anmeldenummer: 16159866.9
(22) Anmeldetag: 11.03.2016
(51) Int. Cl.: H01H 1/00

(54) **VERFAHREN UND SCHALTVORRICHTUNG ZUM SCHALTEN EINES ELEKTRISCHEN VERBRAUCHERS**

(30) Priorität: 29.04.2015 DE 102015207859
(71) Anmelder: ROBERT BOSCH GMBH, 70442 Stuttgart (DE)
(72) Erfinder: Schwaiger, Stephan, 71229 Leonberg (DE); Leidich, Stefan, 71277 Rutesheim (DE)

(57) **Zusammenfassung**

Die Erfindung betrifft ein Verfahren zum Schalten eines elektrischen Verbrauchers. Dabei ist das Verfahren in Verbindung mit einer Schaltvorrichtung (110) zum Schalten eines elektrischen Verbrauchers ausführbar. Die Schaltvorrichtung (110) weist zumindest eine mikroelektromechanische Schalteinrichtung (214) zum Steuern einer Versorgung des elektrischen Verbrauchers mit elektrischem Strom in einem Schaltzustand der Schaltvorrichtung (110) auf. Auch weist die Schaltvorrichtung (110) ein Halbleitersubstrat (212) auf, an dem die zumindest eine mikroelektromechanische Schalteinrichtung (214) angeordnet ist. Ferner weist die Schaltvorrichtung (110) eine Halbleiterschalteinrichtung (216) zum Steuern einer Versorgung des elektrischen Verbrauchers mit elektrischem Strom bei einem Umschaltvorgang der Schaltvorrichtung (110) auf. Hierbei ist die Halbleiterschalteinrichtung (216) in dem Halbleitersubstrat (212) ausgeformt, wobei die Halbleiterschalteinrichtung (216) ausgebildet ist, um eine höhere elektrische Leistung zu schalten als die zumindest eine mikroelektromechanische Schalteinrichtung (214). Das Verfahren weist einen Schritt des Umschaltens der Halbleiterschalteinrichtung (216) von einem ersten Schaltzustand in einen zweiten Schaltzustand auf. Auch weist das Verfahren einen Schritt des Versetzens der zumindest einen mikroelektromechanischen Schalteinrichtung (214) von dem ersten Schaltzustand in den zweiten Schaltzustand auf. Zudem weist das Verfahren einen Schritt des Zurückschaltens der Halbleiterschalteinrichtung (216) von dem zweiten Schaltzustand in den ersten Schaltzustand auf.

## Beschreibung

### Stand der Technik

Die vorliegende Erfindung bezieht sich auf ein Verfahren zum Schalten eines elektrischen Verbrauchers, auf ein Verfahren zum Herstellen einer Schaltvorrichtung zum Schalten eines elektrischen Verbrauchers, auf ein entsprechendes Steuergerät, auf eine Schaltvorrichtung zum Schalten eines elektrischen Verbrauchers, auf eine Schaltsteckdose für einen elektrischen Verbraucher sowie auf ein entsprechendes Computerprogramm.

Ein Schalten von ohmschen Verbrauchern wie beispielsweise Heizungen, Glühlampen oder dergleichen, ohmsch-induktiven Verbrauchern wie zum Beispiel Motoren, Kompressoren etc. oder getakteten Verbrauchern wie beispielsweise Unterhaltungselektronik kann nach wie vor eine Standardaufgabe insbesondere auf dem Gebiet der Gerätetechnik darstellen.

### Offenbarung der Erfindung

Vor diesem Hintergrund werden mit dem hier vorgestellten Ansatz ein Verfahren zum Schalten eines elektrischen Verbrauchers, ein Verfahren zum Herstellen einer Schaltvorrichtung zum Schalten eines elektrischen Verbrauchers, ein Steuergerät, das ein solches Verfahren verwendet, eine Schaltvorrichtung zum Schalten eines elektrischen Verbrauchers, weiterhin eine Schaltsteckdose für einen elektrischen Verbraucher sowie schließlich ein entsprechendes Computerprogramm gemäß den Hauptansprüchen vorgestellt. Vorteilhafte Ausgestaltungen ergeben sich aus den jeweiligen Unteransprüchen und der nachfolgenden Beschreibung.

Gemäß Ausführungsformen der vorliegenden Erfindung können insbesondere Schaltverfahren und Schaltvorrichtungen für elektrische Verbraucher bereitgestellt werden, wobei eine Schutzfunktion bzw. Schutzvorrichtung für Kontakte bei Schaltvorgängen vorgesehen ist. Dabei kann beispielsweise eine zu schaltende elektrische Leistung auf mehrere Pfade aufteilbar sein, wobei ein erster Pfad zumindest einen mikroelektromechanischen Schalter aufweist und ein zweiter Pfad einen Halbleiterschalter aufweist. Es kann hierbei ein Halbleitersubstrat insbesondere sowohl als ein Träger für zumindest einen mikroelektromechanischen Schalter als auch zum Ausbilden eines Halbleiterschalters genutzt werden. Somit können ein Halbleiterschalter und zumindest ein mikroelektromechanischer Schalter beispielsweise als eine mikroelektromechanische Schaltervorrichtung mit integrierter Schutzvorrichtung unter Verwendung eines gemeinsamen Substrates ausgeführt sein oder werden.

Vorteilhafterweise kann gemäß Ausführungsformen der vorliegenden Erfindung insbesondere eine Schaltfunktion so umgesetzt werden, dass eine Bauraumverkleinerung und auch eine Verlustleistungsminimierung mit dem Vorteil einer weniger aufwendigen Wärmeabfuhr erreicht werden kann. Eine vorgeschlagene Realisierung einer Schutzschaltung für Kontakte zumindest eines mikroelektromechanischen Schalters kann den Vorteil bieten, eine Kontaktzuverlässigkeit beim Schalten sowie eine Anzahl möglicher Schaltvorgänge zu erhöhen. Dabei kann auf externe Schaltungselemente verzichtet werden und können optional auch notwendige Teile mehrfach verwendet werden. Insbesondere eine Funktionalisierung eines bisher passiven Halbleitersubstrats durch Integration eines Halbleiterschalters kann zu einem miniaturisieren Bauteil mit weniger thermischer Verlustleistung und somit weniger aufwendiger Kühlung führen. Die Funktionalisierung des Substrats kann verglichen mit einer Verschaltung individueller, auf getrennten Substraten angeordneter Bauelemente eine Reduzierung von Kosten und Platz bewirken.

Es wird ein Verfahren zum Schalten eines elektrischen Verbrauchers vorgestellt, wobei das Verfahren in Verbindung mit einer Schaltvorrichtung zum Schalten eines elektrischen Verbrauchers ausführbar ist, die zumindest eine mikroelektromechanische Schalteinrichtung zum Steuern einer Versorgung des elektrischen Verbrauchers mit elektrischem Strom in einem Schaltzustand der Schaltvorrichtung, ein Halbleitersubstrat, an dem die zumindest eine mikroelektromechanische Schalteinrichtung angeordnet ist, und eine Halbleiterschalteinrichtung zum Steuern einer Versorgung des elektrischen Verbrauchers mit elektrischem Strom bei einem Umschaltvorgang der Schaltvorrichtung aufweist, wobei die Halbleiterschalteinrichtung in dem Halbleitersubstrat ausgeformt ist, wobei die Halbleiterschalteinrichtung ausgebildet ist, um eine höhere elektrische Leistung zu schalten als die zumindest eine mikroelektromechanische Schalteinrichtung, wobei das Verfahren folgende Schritte aufweist:
Umschalten der Halbleiterschalteinrichtung von einem ersten Schaltzustand in einen zweiten Schaltzustand;
Versetzen der zumindest einen mikroelektromechanischen Schalteinrichtung von dem ersten Schaltzustand in den zweiten Schaltzustand; und
Zurückschalten der Halbleiterschalteinrichtung von dem zweiten Schaltzustand in den ersten Schaltzustand.

Der elektrische Verbraucher kann auch als ein Netzspannungsverbraucher bezeichnet werden. Somit kann der elektrische Verbraucher ein Verbraucher an einem öffentlichen, stationären Versorgungsnetz sein. Durch Ausführen des Verfahrens zum Schalten kann der elektrische Verbraucher aktiviert und deaktiviert oder eingeschaltet und ausgeschaltet werden. Die zumindest eine mikroelektromechanische Schalteinrichtung und die Halbleiterschalteinrichtung können auf und/oder in einem Chip integriert sein. Die Halbleiterschalteinrichtung kann als ein Triac oder dergleichen ausgeführt sein. Ein Triac kann ein Halbleiterbauelement repräsentieren, das in zwei Stromflussrichtungen sperren kann und somit für ein Schalten von Wechselspannung geeignet ist. Die Halbleiterschalteinrichtung kann eine höhere Spannung als die zumindest eine mikroelektromechanische Schalteinrichtung zerstörungsfrei schalten. Die zumindest eine mikroelektromechanische Schalteinrichtung kann zumindest einen elektrischen Kontakt aufweisen, der geöffnet und geschlossen werden kann. Bei den Schaltzuständen kann es ich um einen geöffneten Zustand und um einen geschlossenen Zustand handeln. Die Schaltzustände können einen elektrischen Stromfluss und einen unterbrochenen Stromfluss repräsentieren.

Gemäß einer Ausführungsform können der Schritt des Umschaltens, der Schritt des Versetzens und der Schritt des Zurückschaltens in dieser Reihenfolge ausgeführt werden, um den elektrischen Verbraucher einzuschalten. Hierbei kann der erste Schaltzustand einen geöffneten Zustand repräsentieren und kann der zweite Schaltzustand einen geschlossenen Zustand repräsentieren. Alternativ oder zusätzlich können der Schritt des Umschaltens, der Schritt des Versetzens und der Schritt des Zurückschaltens in dieser Reihenfolge ausgeführt werden, um den elektrischen Verbraucher auszuschalten. Dabei kann der erste Schaltzustand einen geschlossenen Zustand repräsentieren und kann der zweite Schaltzustand einen geöffneten Zustand repräsentieren. Eine solche Ausführungsform bietet den Vorteil, dass eine Zuverlässigkeit der zumindest einen mikroelektromechanischen Schalteinrichtung beim Schalten unter Last erhöht werden kann.

Es wird auch ein Verfahren zum Herstellen einer Schaltvorrichtung zum Schalten eines elektrischen Verbrauchers vorgestellt, wobei das Verfahren folgende Schritte aufweist:
Bereitstellen eines Halbleitersubstrats;
Ausformen einer Halbleiterschalteinrichtung zum Steuern einer Versorgung des elektrischen Verbrauchers mit elektrischem Strom bei einem Umschaltvorgang der Schaltvorrichtung in dem Halbleitersubstrat; und
Anordnen zumindest einer mikroelektromechanischen Schalteinrichtung zum Steuern einer Versorgung des elektrischen Verbrauchers mit elektrischem Strom in einem Schaltzustand der Schaltvorrichtung an dem Halbleitersubstrat, wobei die Halbleiterschalteinrichtung ausgebildet ist, um eine höhere elektrische Leistung zu schalten als die zumindest eine mikroelektromechanische Schalteinrichtung.

Durch Ausführen des Verfahrens zum Herstellen kann eine vorteilhafte Ausführungsform einer Schaltvorrichtung zum Schalten eines elektrischen Verbrauchers hergestellt werden.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form eines Steuergeräts kann die der Erfindung zugrunde liegende Aufgabe schnell und effizient gelöst werden.

Unter einem Steuergerät kann vorliegend ein elektrisches Gerät verstanden werden, das Eingangssignale oder Sensorsignale verarbeitet und in Abhängigkeit davon Schalt-, Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Es wird ferner eine Schaltvorrichtung zum Schalten eines elektrischen Verbrauchers vorgestellt, wobei die Schaltvorrichtung folgende Merkmale aufweist:
zumindest eine mikroelektromechanische Schalteinrichtung zum Steuern einer Versorgung des elektrischen Verbrauchers mit elektrischem Strom in einem Schaltzustand der Schaltvorrichtung;
ein Halbleitersubstrat, an dem die zumindest eine mikroelektromechanische Schalteinrichtung angeordnet ist; und
eine Halbleiterschalteinrichtung zum Steuern einer Versorgung des elektrischen Verbrauchers mit elektrischem Strom bei einem Umschaltvorgang der Schaltvorrichtung, wobei die Halbleiterschalteinrichtung in dem Halbleitersubstrat ausgeformt ist, wobei die Halbleiterschalteinrichtung ausgebildet ist, um eine höhere elektrische Leistung zu schalten als die zumindest eine mikroelektromechanische Schalteinrichtung.

Die Schaltvorrichtung ist in Verbindung mit einer Ausführungsform des vorstehend genannten Verfahrens zum Schalten verwendbar, um einen elektrischen Verbraucher zu schalten. Auch ist die Schaltvorrichtung durch Ausführen einer Ausführungsform des vorstehend genannten Verfahrens zum Herstellen herstellbar.

Gemäß einer Ausführungsform können die zumindest eine mikroelektromechanische Schalteinrichtung und die Halbleiterschalteinrichtung elektrisch zueinander parallel geschaltet sein. Zusätzlich oder alternativ können an dem Halbleitersubstrat eine Mehrzahl von zueinander parallel geschalteten mikroelektromechanischen Schalteinrichtungen angeordnet sein. Auch kann die zumindest eine mikroelektromechanischen Schalteinrichtungen eine Mehrzahl von zueinander parallel geschalteten elektrischen Kontakten aufweisen, die geöffnet und geschlossen werden können. Eine solche Ausführungsform bietet den Vorteil, dass bei einem Schaltvorgang eine Belastung für die zumindest eine mikroelektromechanische Schalteinrichtung weiter verringert werden kann, insbesondere indem parallele Strompfade mit geeigneter Stromfestigkeit bereitgestellt sind bzw. werden, die für einen sequenziellen Schaltvorgang geeignet sind.

Auch kann die Schaltvorrichtung eine Ausführungsform des vorstehend genannten Steuergeräts aufweisen. Eine solche Ausführungsform bietet den Vorteil, dass ein elektrischer Verbraucher langfristig zuverlässig und/oder verschleißarm geschaltet werden kann.

Es wird zudem eine Schaltsteckdose für einen elektrischen Verbraucher vorgestellt, wobei die Schaltsteckdose eine Ausführungsform der vorstehend genannten Schaltvorrichtung aufweist, die ausgebildet ist, um den elektrischen Verbraucher zu schalten.

In Verbindung mit der Schaltsteckdose kann eine Ausführungsform der vorstehend genannten Schaltvorrichtung vorteilhaft eingesetzt bzw. verwendet werden, um den elektrischen Verbraucher zu schalten. Der elektrische Verbraucher kann in die Schaltsteckdose einsteckbar sein, um den elektrischen Verbraucher schaltbar mit elektrischer Leistung zu versorgen. Dabei kann die Schaltsteckdose und zusätzlich oder alternativ die Schaltvorrichtung fernsteuerbar sein, beispielsweise per Funk oder dergleichen.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Der hier vorgestellte Ansatz wird nachstehend anhand der beigefügten Zeichnungen beispielhaft näher erläutert. Es zeigen:
Fig. 1 eine schematische Darstellung einer Schaltsteckdose gemäß einem Ausführungsbeispiel der vorliegenden Erfindung;
Fig. 2 eine schematische Schnittdarstellung einer Schaltvorrichtung gemäß einem Ausführungsbeispiel der vorliegenden Erfindung;
Fig. 3 eine schematische Draufsichtdarstellung einer Schaltvorrichtung gemäß einem Ausführungsbeispiel der vorliegenden Erfindung;
Fig. 4 eine schematische Darstellung eines Steuergeräts gemäß einem Ausführungsbeispiel der vorliegenden Erfindung;
Fig. 5 ein Ablaufdiagramm eines Verfahrens zum Schalten gemäß einem Ausführungsbeispiel der vorliegenden Erfindung; und
Fig. 6 ein Ablaufdiagramm eines Verfahrens zum Herstellen gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

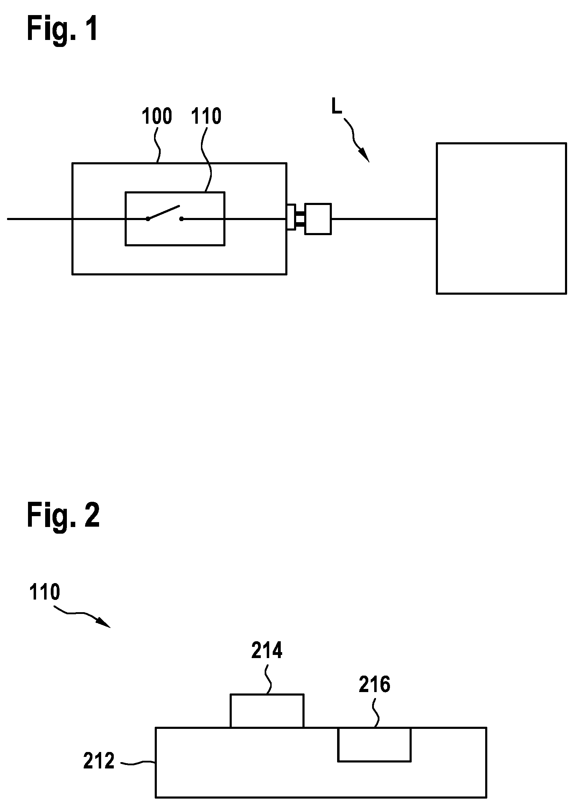

Fig. 1 zeigt eine schematische Darstellung einer Schaltsteckdose 100 gemäß einem Ausführungsbeispiel der vorliegenden Erfindung. In die Schaltsteckdose 100 ist in der Darstellung von Fig. 1 ein elektrischer Verbraucher L bzw. eine Last eingesteckt. Die Schaltsteckdose 100 ist ausgebildet, um den elektrischen Verbraucher L mit elektrischer Leistung zu versorgen. Dabei ist die Schaltsteckdose 100 insbesondere ausgebildet, um den elektrischen Verbraucher L mit einem öffentlichen, stationären Versorgungsnetz elektrisch leitfähig zu verbinden oder von demselben elektrisch zu trennen. Das Versorgungsnetz kann hierbei eine Versorgungsspannung aufweisen.

Dazu weist die Schaltsteckdose 100 eine Schaltvorrichtung 110 auf. Die Schaltvorrichtung 110 ist ausgebildet, um den elektrischen Verbraucher L zu schalten. Anders ausgedrückt ist die Schaltvorrichtung 110 ausgebildet, um einen elektrischen Stromfluss durch den elektrischen Verbraucher L zu aktivieren und zu deaktivieren bzw. zu ermöglichen und zu unterbrechen. Die Schaltvorrichtung 110 wird nachfolgend noch genauer beschrieben.

Die Schaltsteckdose 100, die auch als ein so genannter Smart Plug bezeichnet werden kann, ist ausgebildet, um eine Fernschaltung und/oder zeitlich bedarfsgerechte Aktivierung des elektrischen Verbrauchers L bzw. eine Fernsteuerung des elektrischen Verbrauchers L beispielsweise über ein Smartphone und/oder über das Internet zu bewirken oder zu ermöglichen.

Fig. 2 zeigt eine schematische Schnittdarstellung einer Schaltvorrichtung 110 gemäß einem Ausführungsbeispiel der vorliegenden Erfindung. Bei der in Fig. 2 gezeigten Schaltvorrichtung 110 handelt es sich um die Schaltvorrichtung aus Fig. 1 oder eine ähnliche Schaltvorrichtung zum Schalten eines elektrischen Verbrauchers. Anders ausgedrückt entspricht die Schaltvorrichtung aus Fig. 1 der in Fig. 2 dargestellten Schaltvorrichtung 110 oder einer ähnlichen Schaltvorrichtung zum Schalten eines elektrischen Verbrauchers.

Die Schaltvorrichtung 110 ist ausgebildet, um den elektrischen Verbraucher zu schalten, genauer gesagt einen elektrischen Stromfluss durch den elektrischen Verbraucher zu aktivieren und zu deaktivieren. Die Schaltvorrichtung 110 weist gemäß dem in Fig. 2 gezeigten Ausführungsbeispiel der vorliegenden Erfindung ein Halbleitersubstrat 212, beispielhaft lediglich eine mikroelektromechanische Schalteinrichtung 214 und eine Halbleiterschalteinrichtung 216 auf.

Das Halbleitersubstrat 212 ist hierbei aus einem Halbleitermaterial ausgeformt. Beispielsweise weist das Halbleitersubstrat 212 Silizium als Halbleitermaterial auf. Das Halbleitersubstrat 212 ist ausgebildet, um als eine mechanische und/oder funktionale Basis für die mikroelektromechanische Schalteinrichtung 214 und für die Halbleiterschalteinrichtung 216 zu dienen.

Die mikroelektromechanische Schalteinrichtung 214 ist an dem Halbleitersubstrat 212 angeordnet. Hierbei ist die mikroelektromechanische Schalteinrichtung 214 an einer Oberfläche oder Hauptoberfläche des Halbleitersubstrates 212 angeordnet. Die mikroelektromechanische Schalteinrichtung 214 ist ausgebildet, um eine Versorgung des elektrischen Verbrauchers mit elektrischem Strom in einem Schaltzustand der Schaltvorrichtung 110 zu steuern. Auch wenn es in Fig. 2 nicht explizit gezeigt ist, weist die mikroelektromechanische Schalteinrichtung 214 zumindest einen elektrischen Kontakt auf, wobei die mikroelektromechanische Schalteinrichtung 214 ausgebildet ist, um den zumindest einen Kontakt zu öffnen und zu schließen.

Die Halbleiterschalteinrichtung 216 ist in dem Halbleitersubstrat 212 ausgeformt. Dabei ist die Halbleiterschalteinrichtung 216 gemäß dem in Fig. 2 gezeigten Ausführungsbeispiel der vorliegenden Erfindung benachbart zu der Oberfläche des Halbleitersubstrates 212 ausgeformt, an der mikroelektromechanische Schalteinrichtung 214 angeordnet ist. Die Halbleiterschalteinrichtung 216 ist ausgebildet, um die Versorgung des elektrischen Verbrauchers mit elektrischem Strom bei einem Umschaltvorgang der Schaltvorrichtung 110 zu steuern. Insbesondere weist auch die Halbleiterschalteinrichtung 216 zumindest einen elektrischen Kontakt auf, wobei die Halbleiterschalteinrichtung 216 ausgebildet ist, um den zumindest einen Kontakt zu öffnen und zu schließen, auch wenn es in Fig. 2 nicht explizit dargestellt ist. Die Halbleiterschalteinrichtung 216 ist unter Verwendung des Halbleitermaterials des Halbleitersubstrates 212 ausgeformt. Auch ist die Halbleiterschalteinrichtung 216 ausgebildet, um eine höhere elektrische Leistung zu schalten als die mikroelektromechanische Schalteinrichtung 214. Erste Seite kann die Halbleiterschalteinrichtung 216 eine höhere Stromfestigkeit und/oder Spannungsfestigkeit als die mikroelektromechanische Schalteinrichtung 214 aufweisen. Beispielsweise kann die Arbeitszustand ein MEMS-Schalter als mikroelektromechanische Schalteinrichtung 214 den gesamten Laststrom tragen. Ein Triac als Halbleiterschalteinrichtung 216 hilft nur beim eigentlichen Schaltvorgang. Der MEMS-Schalter 214 würde beim Trennen des Stroms sofort verschmelzen. Auch die Annäherung der Kontakte der mikroelektromechanischen Schalteinrichtung 214 unter voller Netz- bzw. Lastspannung würde kurz vor dem ohmschen Kontakt zu einem Durchschlag führen.

Gemäß einem Ausführungsbeispiel kann die Schaltvorrichtung 110 eine Mehrzahl von mikroelektromechanischen Schalteinrichtungen wie die mikroelektromechanische Schalteinrichtung 214 aufweisen. Zusätzlich oder alternativ kann die mikroelektromechanische Schalteinrichtung 214 eine Mehrzahl von elektrischen Kontakten aufweisen.

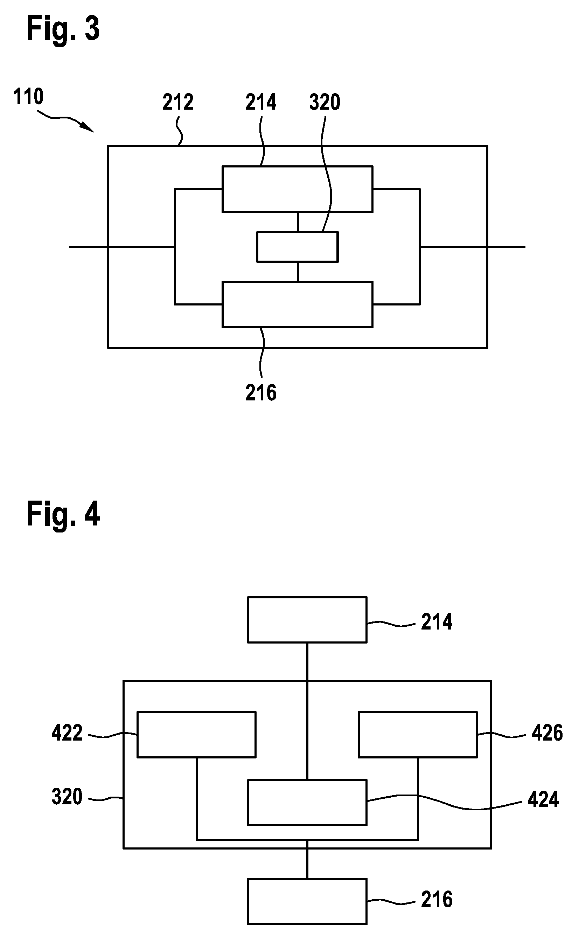

Fig. 3 zeigt eine schematische Draufsichtsdarstellung einer Schaltvorrichtung 110 gemäß einem Ausführungsbeispiel der vorliegenden Erfindung. Bei der in Fig. 3 gezeigten Schaltvorrichtung 110 handelt es sich um die Schaltvorrichtung aus Fig. 1 bzw. Fig. 2 oder eine ähnliche Schaltvorrichtung zum Schalten eines elektrischen Verbrauchers. Anders ausgedrückt entspricht die Schaltvorrichtung aus Fig. 1 bzw. Fig. 2 der in Fig. 3 dargestellten Schaltvorrichtung 110 oder einer ähnlichen Schaltvorrichtung zum Schalten eines elektrischen Verbrauchers.

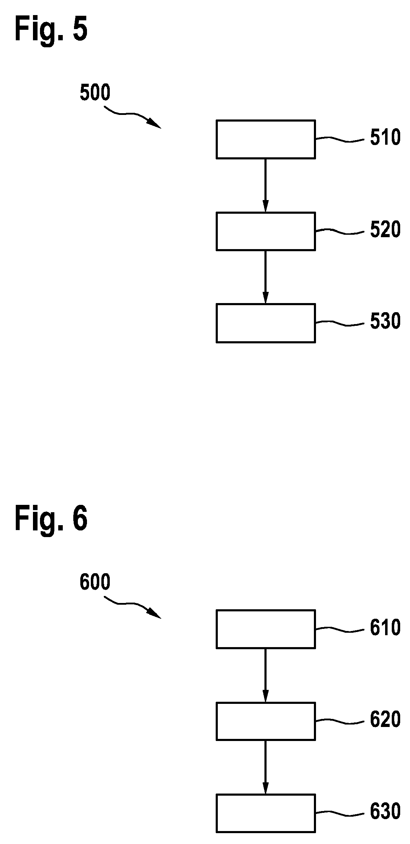

Gemäß dem in Fig. 3 dargestellten Ausführungsbeispiel der vorliegenden Erfindung weist die Schaltvorrichtung 110 das Halbleitersubstrat 212, die mikroelektromechanische Schalteinrichtung 214, die Halbleiterschalteinrichtung 216 und ein Steuergerät 320 auf. Das Steuergerät 320 ist hierbei signalübertragungsfähig mit der mikroelektromechanischen Schalteinrichtung 214 und mit der Halbleiterschalteinrichtung 216 verbunden. Dabei ist das Steuergerät 320 ausgebildet, um alle Schritte eines nachfolgend unter Bezugnahme auf Fig. 5 beschriebenen Verfahrens zum Schalten eines elektrischen Verbrauchers durchzuführen, umzusetzen und/oder anzusteuern. Dazu weist das Steuergerät 320 zum Durchführen der Schritte des Verfahrens entsprechende Einrichtungen auf, wie es unter Bezugnahme auf Fig. 4 noch genauer erläutert wird.

In Fig. 3 ist erkennbar, dass die mikroelektromechanische Schalteinrichtung 214 und die Halbleiterschalteinrichtung 216 elektrisch zueinander parallel geschaltet sind. Gemäß einem Ausführungsbeispiel kann die Schaltvorrichtung 110 auch eine Mehrzahl von zueinander parallel geschalteten mikroelektromechanischen Schalteinrichtungen 214 und/oder zumindest eine mikroelektromechanische Schalteinrichtung 214 mit einer Mehrzahl von zueinander parallel geschalteten elektrischen Kontakten aufweisen.

Fig. 4 zeigt eine schematische Darstellung eines Steuergeräts 320 gemäß einem Ausführungsbeispiel der vorliegenden Erfindung. Das in Fig. 4 gezeigte Steuergerät 320 entspricht hierbei dem Steuergerät aus Fig. 3. Zu Veranschaulichungszwecken sind ferner die mikroelektromechanische Schalteinrichtung 214 sowie die Halbleiterschalteinrichtung 216 aus Fig. 3 auch in Fig. 4 dargestellt. Das Steuergerät 320 ist ausgebildet, um alle Schritte eines nachfolgend unter Bezugnahme auf Fig. 5 beschriebenen Verfahrens zum Schalten eines elektrischen Verbrauchers durchzuführen, umzusetzen und/oder anzusteuern. Anders ausgedrückt ist das Steuergerät 320 ausgebildet, um einen Schaltvorgang zum Aktivieren und/oder Deaktivieren eines elektrischen Stromflusses durch den elektrischen Verbraucher durchzuführen.

Das Steuergerät 320 ist signalübertragungsfähig mit der mikroelektromechanischen Schalteinrichtung 214 und mit der Halbleiterschalteinrichtung 216 verbunden. Dabei weist das Steuergerät 320 eine Umschalteinrichtung 422, eine Versetzungseinrichtung 424 und eine Zurückschalteinrichtung 426 auf. Hierbei sind die Umschalteinrichtung 422 und die Zurückschalteinrichtung 426 signalübertragungsfähig mit der Halbleiterschalteinrichtung 216 verbunden. Die Versetzungseinrichtung 424 ist signalübertragungsfähig mit der mikroelektromechanischen Schalteinrichtung 214 verbunden.

Die Umschalteinrichtung 422 ist ausgebildet, um die Halbleiterschalteinrichtung 216 von einem ersten Schaltzustand in einen zweiten Schaltzustand umzuschalten. Die Versetzungseinrichtung 424 ist ausgebildet, um die mikroelektromechanische Schalteinrichtung 214 von dem ersten Schaltzustand in den zweiten Schaltzustand zu versetzen. Die Zurückschalteinrichtung 426 ist ausgebildet, um die Halbleiterschalteinrichtung 216 von dem zweiten Schaltzustand in den ersten Schaltzustand zurückzuschalten. Bei einem Schaltvorgang, der durch das Steuergerät 320 durchführbar ist, sind die Funktion der Umschalteinrichtung 422, die Funktion der Versetzungseinrichtung 424 und die Funktion der Zurückschalteinrichtung 426 in dieser Reihenfolge ausführbar bzw. ansteuerbar.

Fig. 5 zeigt ein Ablaufdiagramm eines Verfahrens 500 zum Schalten eines elektrischen Verbrauchers. Das Verfahren 500 ist in Verbindung mit einer Schaltvorrichtung zum Schalten eines elektrischen Verbrauchers wie der Schaltvorrichtung aus Fig. 1 bzw. Fig. 2 ausführbar. Insbesondere ist das Verfahren 500 unter Verwendung eines Steuergerätes wie des Steuergerätes aus Fig. 2 bzw. Fig. 3 ausführbar.

Das Verfahren 500 weist einen Schritt 510 des Umschaltens, einen Schritt 520 des Versetzens und einen Schritt 530 des Zurückschaltens auf. Dabei werden der Schritt 510 des Umschaltens, der Schritt 520 des Versetzens und der Schritt 530 des Zurückschaltens in dieser Reihenfolge ausgeführt, um einen Schaltvorgang durchzuführen. Ein Schaltvorgang entspricht hierbei einem Aktivieren oder einem Deaktivieren eines elektrischen Stromflusses durch den elektrischen Verbraucher hindurch.

In dem Schritt 510 des Umschaltens wird die Halbleiterschalteinrichtung von einem ersten Schaltzustand in einen zweiten Schaltzustand umgeschaltet. In dem Schritt 520 des Versetzens wird die zumindest eine mikroelektromechanische Schalteinrichtung von dem ersten Schaltzustand in den zweiten Schaltzustand versetzt. In dem Schritt 530 des Zurückschaltens wird die Halbleiterschalteinrichtung von dem zweiten Schaltzustand in den ersten Schaltzustand zurückgeschaltet.

Bei einem ersten Schaltvorgang, der ein Aktivieren des elektrischen Stromflusses durch den elektrischen Verbraucher hindurch repräsentiert, handelt es sich bei den ersten Schaltzustand der Schalteinrichtungen um einen geöffneten Zustand und handelt es sich bei dem zweiten Schaltzustand um einen geschlossenen Zustand. Bei einem zweiten Schaltvorgang, der ein Deaktivieren des elektrischen Stromflusses durch den elektrischen Verbraucher hindurch repräsentiert, handelt es sich bei den ersten Schaltzustand der Schalteinrichtungen um einen geschlossenen Zustand und handelt es sich bei dem zweiten Schaltzustand um einen geöffneten Zustand.

Nachfolgend wird eine Schaltsequenz beschrieben, die den ersten Schaltvorgang und den zweiten Schaltvorgang umfasst. Dabei wird die Halbleiterschalteinrichtung auch als ein Halbleiterschalter bezeichnet und wird die mikroelektromechanische Schalteinrichtung auch als ein MEMS-Schalter (MEMS = microelectromechanical system; mikroelektromechanisches System) bezeichnet.

In einer Ausgangssituation ist der Halbleiterschalter deaktiviert und ist der zumindest eine MEMS-Schalter deaktiviert. Somit erfolgt kein Stromfluss durch den elektrischen Verbraucher. Dann wird der Verbraucher durch Aktivieren des Halbleiterschalters eingeschaltet. Der Halbleiterschalter trägt anfänglich den gesamten Strom. Danach wird durch Aktivieren des zumindest einen MEMS-Schalters wird der Strom übergeben. Eine über den Schaltern anliegende Spannung im Moment des Schließens der Kontakte entspricht beispielsweise dabei lediglich einer Restspannung des Halbleiterbauelements und nicht einer vollen Netzspannung. Eine Belastung der Kontakte ist somit reduziert. Für einen normalen Betriebszustand des Verbrauchers wird der Halbleiterschalter wieder deaktiviert. Dadurch entsteht an dem Halbleiterschalter im wesentlichen keine Verlustleistung. Thermische Verluste an dem zumindest einen MEMS-Schalter sind beispielsweise geringer als im Falle eines Relais oder Triac. Ein reduzierter Widerstand wird insbesondere durch Verwendung einer geeigneten Anzahl von Parallelkontakten des MEMS-Schalters erreicht.

Zum Abschalten des Verbrauchers wird zunächst der Halbleiterschalter aktiviert. Dieser trägt zunächst keinen Strom, da ein Laststrom an dem Widerstand der MEMS-Kontakte lediglich eine geringe Spannung, beispielsweise etwa 100 Millivolt im Falle einer Spannungsversorgung durch ein übliches öffentliches Versorgungsnetz, verursacht. Durch Deaktivieren der MEMS-Schalter wird der Strom an den Halbleiterschalter übergeben. Der Abschaltvorgang an den Kontakten umfasst dabei den Rückgang des Stroms vom maximalen Laststrom zu Null und den Anstieg der Spannung von einem kleinen Wert (beispielsweise den genannten ungefähr 100 Millivolt) bis zu einer Restspannung des Halbleiterbauelements (von beispielsweise 1 Volt). Somit können kritische Spannungsüberhöhungen, die beispielsweise größer oder gleich einer anliegenden Netzspannung (beispielsweise Uₚₚ =350 Volt) verhindert werden. Durch Deaktivieren des Halbleiterschalters wird der Verbraucher schließlich ausgeschaltet.

Durch eine Umsetzung der beschriebenen Sequenz ist eine Belastung der MEMS-Kontakte minimierbar. Eine Zuverlässigkeitssteigerung von aktuell etwa 1000 auf etwa 10⁵ zulässige Schaltzyklen kann ermöglicht werden. Dies entspricht beispielsweise Zuverlässigkeitskennwerten typischer Relais.

Fig. 6 zeigt ein Ablaufdiagramm eines Verfahrens 600 zum Herstellen einer Schaltvorrichtung zum Schalten eines elektrischen Verbrauchers. Durch Ausführen des Verfahrens 600 ist eine Schaltvorrichtung wie die Schaltvorrichtung aus Fig. 1 bzw. Fig. 2 herstellbar.

Das Verfahren 600 weist einen Schritt 610 des Bereitstellens eines Halbleitersubstrats auf. In einem Schritt 620 des Ausformens wird eine Halbleiterschalteinrichtung zum Steuern einer Versorgung des elektrischen Verbrauchers mit elektrischem Strom bei einem Umschaltvorgang der Schaltvorrichtung in dem Halbleitersubstrat ausgeformt. Nachfolgend wird in einem Schritt 630 des Anordnens zumindest eine mikroelektromechanische Schalteinrichtung zum Steuern einer Versorgung des elektrischen Verbrauchers mit elektrischem Strom in einem Schaltzustand der Schaltvorrichtung an dem Halbleitersubstrat angeordnet. Dabei wird die Halbleiterschalteinrichtung im Schritt 620 des Ausformens so ausgeformt, dass sie ausgebildet ist, um eine höhere elektrische Leistung zu schalten als die zumindest eine mikroelektromechanische Schalteinrichtung.

Gemäß einem Ausführungsbeispiel wird der Schritt 620 des Ausformens vor dem Schritt 630 des Anordnens ausgeführt. Anders ausgedrückt werden hierbei mikroelektronische Prozesse zur Herstellung der Halbleiterschalteinrichtung vor MEMS-Prozessen zur Herstellung der zumindest einen mikroelektromechanischen Schalteinrichtung durchgeführt. So lassen sich sowohl Halbleiterschalteinrichtung als auch zumindest eine mikroelektromechanische Schalteinrichtung auf Chipebene integrieren. Insbesondere wird die Halbleiterschalteinrichtung wird mit einer Mehrzahl von parallel geschalteten mikroelektromechanischen Schalteinrichtungen parallel geschaltet. Das Halbleiterbauelement bzw. die Halbleiterschalteinrichtung kann somit einen Nebenpfad des Stroms realisieren.

Nachfolgend werden Ausführungsbeispiele und Hintergründe der vorliegenden Erfindung zusammenfassend und mit anderen Worten unter Bezugnahme auf die Figuren 1 bis 6 nochmals erläutert.

Die Schaltvorrichtung 110 umfasst hierbei zumindest eine mikroelektromechanische Schalteinrichtung 214 bzw. Mindest einen MEMS-Schalter mit einer Schutzvorrichtung, die in Gestalt der Halbleiterschalteinrichtung 216 ausgeführt ist, zum Schalten von elektrischen Verbrauchern bzw. Netzspannungsverbrauchern. Anders ausgedrückt kann ein Konzept zur Realisierung eines MEMS-Schalters mit Schutzvorrichtung der Kontakte zum Schalten von Netzspannungsverbrauchern mit einer Leistungsaufnahme bis beispielsweise ca. 3 Kilowatt bereitgestellt werden.

Gemäß Ausführungsbeispiel der vorliegenden Erfindung kann vermieden werden, dass zum Schalten von Netzspannungsverbrauchern Relais eingesetzt werden. Relais können mit Hilfe eines Kleinsignaltransistors und einer Freilaufdiode durch ein digitales Signal beispielsweise von einem Mikrocontroller gesteuert werden. Relais können konstruktionsbedingt jedoch vergleichsweise groß sein, wobei typische Abmessungen etwa 20 Millimeter mal 20 Millimeter mal 10 Millimeter betragen können. Eine Leistungsaufnahme eines magnetischen Antriebs eines Relais kann beispielsweise mehr als 100 Milliwatt sein. Ein typischer Kontaktwiderstand kann im Bereich von 30 bis 100 Milliohm liegen. Bei einer Last von beispielsweise 16 Ampere kann eine Verlustleistung zum Beispiel 8 bis 26 Watt betragen.

Eine Alternative zu Relais stellt eine Verwendung von Triacs dar. Im aktivierten Zustand kann über einem Triac eine Restspannung von beispielsweise ca. 0,9 bis 1,2 Volt abfallen. Bei einem Stromfluss von 16 Ampere kann die Verlustleistung ca. 20 Watt betragen. Für eine Wärmeabfuhr oder Entwärmung von 20 Watt thermischer Leistung, was nicht trivial ist, bringt eine Parallelschaltung von Triacs keinen Vorteil, da die Restspannung erhalten bleibt und sich lediglich der Strom aufteilt. Das Parallelschalten von Relais wäre lediglich in dieser Hinsicht als Alternative denkbar, da sich durch eine Verwendung von zwei Relais der Strom aufteilt. Der halbe Strom bewirkt an jedem Relais ein Viertel der Verlustleistung. In der Summe ist der Verlust bzw. die Wärmeleistung halb so groß. Die Verwendung von zwei unabhängigen Relais kann jedoch hinsichtlich der Bauform nachteilig sein. Die Realisierung eines Relais mit mehreren parallelen Kontakten in einem Gehäuse ist nicht trivial, da jedes Kontaktpaar mit einer Mindestkraft zu verpressen ist. Eine Aufteilung einer hierfür benötigten Kraft eines einzelnen Antriebs auf mehrere Kontaktpaare würde ein komplexes Federsystem erfordern.

Mittels MEMS-Technologie ist es gemäß Ausführungsbeispielen möglich, auch eine Parallelschaltung von mehreren Hundert Schaltkontakten zu realisieren. Da beispielsweise jedes Kontaktpaar einen eigenen Antrieb aufweist, kann die Frage der Kraftverteilung vorteilhaft gelöst werden. Durch Vergrößerung einer Chipfläche kann eine Anzahl der Kontakte noch weiter erhöht und somit ein effektiver Kontaktwiderstand gesenkt werden. Um eine Zuverlässigkeit der MEMS-Kontakte bzw. der zumindest einen mikroelektromechanischen Schalteinrichtung 214 beim Schalten unter Last zu verbessern, ist die Schutzvorrichtung in Gestalt der Halbleiterschalteinrichtung 216 vorgesehen. Somit kann verhindert werden, dass ohmsche Kontakte bereits nach wenigen Schaltzyklen (beispielsweise nach 1 bis 1000) degenerieren.

Die zumindest eine mikroelektromechanischen Schalteinrichtung 214 bzw. der zumindest eine MEMS-Schalter kann beispielsweise mittels einer Silizium-Oberflächentechnologie gefertigt werden. Dabei stellt zum Beispiel ein Siliziumwafer das Halbleitersubstrat 212 bzw. ein Ausgangssubstrat dar. Mittels technologischer Prozesse, wie beispielsweise physikalische Gasphasenabscheidung (englisch: physical vapour deposition, kurz PVD), chemische Gasphasenabscheidung (englisch: chemical vapour deposition, kurz CVD), nasschemisches und plasmachemisches Ätzen, werden hierbei Materialschichten aufgetragen und strukturiert. Das Halbleitersubstrat 212 bzw. Siliziumsubstrat fungiert dabei als ein Träger mit wohldefinierten mechanischen und chemischen Eigenschaften für die zumindest eine mikroelektromechanische Schalteinrichtung 214 und ist zum Ausformen der Halbleiterschalteinrichtung 216 funktionalisiert.

Eine Vielzahl von parallel geschalteten MEMS-Kontakten kann beispielsweise eine Grundfläche von mehreren Quadratmillimetern aufweisen. Ein Produkt aus Widerstand und Grundfläche kann eine Gütezahl bzw. einen Gütefaktor (englisch: Figure of Merit) darstellen, welche durch Prozessoptimierungen minimiert werden kann.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (500) zum Schalten eines elektrischen Verbrauchers (L), wobei das Verfahren (500) in Verbindung mit einer Schaltvorrichtung (110) zum Schalten eines elektrischen Verbrauchers (L) ausführbar ist, die zumindest eine mikroelektromechanische Schalteinrichtung (214) zum Steuern einer Versorgung des elektrischen Verbrauchers (L) mit elektrischem Strom in einem Schaltzustand der Schaltvorrichtung (110), ein Halbleitersubstrat (212), an dem die zumindest eine mikroelektromechanische Schalteinrichtung (214) angeordnet ist, und eine Halbleiterschalteinrichtung (216) zum Steuern einer Versorgung des elektrischen Verbrauchers (L) mit elektrischem Strom bei einem Umschaltvorgang der Schaltvorrichtung (110) aufweist, wobei die Halbleiterschalteinrichtung (216) in dem Halbleitersubstrat (212) ausgeformt ist, wobei die Halbleiterschalteinrichtung (216) ausgebildet ist, um eine höhere elektrische Leistung zu schalten als die zumindest eine mikroelektromechanische Schalteinrichtung (214), wobei das Verfahren (500) folgende Schritte aufweist:
Umschalten (510) der Halbleiterschalteinrichtung (216) von einem ersten Schaltzustand in einen zweiten Schaltzustand;
Versetzen (520) der zumindest einen mikroelektromechanischen Schalteinrichtung (214) von dem ersten Schaltzustand in den zweiten Schaltzustand; und
Zurückschalten (530) der Halbleiterschalteinrichtung (216) von dem zweiten Schaltzustand in den ersten Schaltzustand.

2. Verfahren (500) gemäß Anspruch 1, **dadurch gekennzeichnet, dass** der Schritt (510) des Umschaltens, der Schritt (520) des Versetzens und der Schritt (530) des Zurückschaltens in dieser Reihenfolge ausgeführt werden, um den elektrischen Verbraucher (L) einzuschalten, wobei der erste Schaltzustand einen geöffneten Zustand repräsentiert und der zweite Schaltzustand einen geschlossenen Zustand repräsentiert und/oder wobei der Schritt (510) des Umschaltens, der Schritt (520) des Versetzens und der Schritt (530) des Zurückschaltens in dieser Reihenfolge ausgeführt werden, um den elektrischen Verbraucher (L) auszuschalten, wobei der erste Schaltzustand einen geschlossenen Zustand repräsentiert und der zweite Schaltzustand einen geöffneten Zustand repräsentiert.

3. Verfahren (600) zum Herstellen einer Schaltvorrichtung (110) zum Schalten eines elektrischen Verbrauchers (L), wobei das Verfahren (600) folgende Schritte aufweist:
Bereitstellen (610) eines Halbleitersubstrats (212);
Ausformen (620) einer Halbleiterschalteinrichtung (216) zum Steuern einer Versorgung des elektrischen Verbrauchers (L) mit elektrischem Strom bei einem Umschaltvorgang der Schaltvorrichtung (110) in dem Halbleitersubstrat (212); und
Anordnen (630) zumindest einer mikroelektromechanischen Schalteinrichtung (214) zum Steuern einer Versorgung des elektrischen Verbrauchers (L) mit elektrischem Strom in einem Schaltzustand der Schaltvorrichtung (110) an dem Halbleitersubstrat (212), wobei die Halbleiterschalteinrichtung (216) ausgebildet ist, um eine höhere elektrische Leistung zu schalten als die zumindest eine mikroelektromechanische Schalteinrichtung (214).

4. Steuergerät (320), das ausgebildet ist, um alle Schritte eines Verfahrens (500) gemäß einem der vorangegangenen Ansprüche durchzuführen, umzusetzen und/oder anzusteuern.

5. Schaltvorrichtung (110) zum Schalten eines elektrischen Verbrauchers (L), wobei die Schaltvorrichtung (110) folgende Merkmale aufweist:
zumindest eine mikroelektromechanische Schalteinrichtung (214) zum Steuern einer Versorgung des elektrischen Verbrauchers (L) mit elektrischem Strom in einem Schaltzustand der Schaltvorrichtung (110);
ein Halbleitersubstrat (212), an dem die zumindest eine mikroelektromechanische Schalteinrichtung (214) angeordnet ist; und
eine Halbleiterschalteinrichtung (216) zum Steuern einer Versorgung des elektrischen Verbrauchers (L) mit elektrischem Strom bei einem Umschaltvorgang der Schaltvorrichtung (110), wobei die Halbleiterschalteinrichtung (216) in dem Halbleitersubstrat (212) ausgeformt ist, wobei die Halbleiterschalteinrichtung (216) ausgebildet ist, um eine höhere elektrische Leistung zu schalten als die zumindest eine mikroelektromechanische Schalteinrichtung (214).

6. Schaltvorrichtung (110) gemäß Anspruch 5, **dadurch gekennzeichnet, dass** die zumindest eine mikroelektromechanische Schalteinrichtung (214) und die Halbleiterschalteinrichtung (216) elektrisch zueinander parallel geschaltet sind und/oder an dem Halbleitersubstrat (212) eine Mehrzahl von zueinander parallel geschalteten mikroelektromechanischen Schalteinrichtungen (214) angeordnet sind.

7. Schaltvorrichtung (110) gemäß einem der Ansprüche 5 bis 6, **dadurch gekennzeichnet, dass** die Schaltvorrichtung (110) ein Steuergerät (320) gemäß Anspruch 4 aufweist.

8. Schaltsteckdose (100) für einen elektrischen Verbraucher (L), wobei die Schaltsteckdose (100) eine Schaltvorrichtung (110) gemäß einem der Ansprüche 5 bis 7 aufweist, die ausgebildet ist, um den elektrischen Verbraucher (L) zu schalten.

9. Computerprogramm, das dazu eingerichtet ist, alle Schritte eines Verfahrens (500; 600) gemäß einem der vorangegangenen Ansprüche durchzuführen, umzusetzen und/oder anzusteuern.

10. Maschinenlesbares Speichermedium mit einem darauf gespeicherten Computerprogramm nach Anspruch 9.
